(19) Europäisches Patentamt
European Patent Office
Office européen des brevets

(11) **EP 4 739 002 A1**

(12) **EUROPEAN PATENT APPLICATION**

(43) Date of publication:
**06.05.2026 Bulletin 2026/19**

(21) Application number: **25203982.1**

(22) Date of filing: **23.09.2025**

(51) International Patent Classification (IPC):
**H05B 45/54** (2020.01)     **G01R 31/52** (2020.01)

(52) Cooperative Patent Classification (CPC):
**H05B 45/54; G01R 31/52**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **31.10.2024 KR 20240152385
24.03.2025 KR 20250037293**

(71) Applicant: **Samsung Electro-Mechanics Co., Ltd.
Suwon-si, Gyeonggi-do 16674 (KR)**

(72) Inventor: **Park, Jeong Hyun
16674 Suwon-si, Gyeonggi-do (KR)**

(74) Representative: **Grünecker Patent- und
Rechtsanwälte
PartG mbB
Leopoldstraße 4
80802 München (DE)**

(54) **LED SHORT DETECTION CIRCUIT AND LED SYSTEM INCLUDING THE SAME**

(57)     A light-emitting diode (LED) short detection circuit includes a first smoothing circuit configured to receive a first LED driving voltage applied to a first end of an LED string and perform smoothing on the first LED driving voltage; a second smoothing circuit configured to receive a second LED driving voltage applied to a second end of the LED string and perform smoothing on the second LED driving voltage; an amplifier configured to amplify a difference between a first smoothing voltage output from the first smoothing circuit and a second smoothing voltage output from the second smoothing circuit to output a detection voltage; and a short-circuit determination circuit configured to compare the detection voltage with a predetermined reference voltage to output a short-circuit signal indicating whether a short-circuit has occurred.

## FIG. 4

EP 4 739 002 A1

**Description**

BACKGROUND

1. Field

The present disclosure relates to an LED short detection circuit and an LED system including the same.

2. Description of the Background

A light-emitting diode (LED) is a semiconductor device that emits light when a current is applied. LEDs are used for a variety of purposes, including lighting and backlighting of displays, and recently, LEDs are also being used in battlefield cameras.

A vehicle-mounted camera is installed inside a vehicle and used to monitor a driver, a passenger, etc. An infrared camera is used to monitor drivers and passengers. In an infrared camera, an infrared LED may be used as a light source.

In the infrared LED used as light sources, multiple LEDs are connected in series with each other. A circuit may be desired to detect even when a problem (short circuit) occurs in at least one LED among the LEDs.

The above information is presented as background information only to assist with an understanding of the present disclosure. No determination has been made, and no assertion is made, as to whether any of the above might be applicable as prior art with regard to the disclosure.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a light-emitting diode (LED) short detection circuit includes a first smoothing circuit configured to receive a first LED driving voltage applied to a first end of an LED string and perform smoothing on the first LED driving voltage; a second smoothing circuit configured to receive a second LED driving voltage applied to a second end of the LED string and perform smoothing on the second LED driving voltage; an amplifier configured to amplify a difference between a first smoothing voltage output from the first smoothing circuit and a second smoothing voltage output from the second smoothing circuit to output a detection voltage; and a short-circuit determination circuit configured to compare the detection voltage with a predetermined reference voltage to output a short-circuit signal indicating whether a short-circuit has occurred.

The LED short detection circuit may further include a buffer configured to receive the second smoothing voltage and output the second smoothing voltage to the amplifier.

The first smoothing circuit may include a first resistor having a first end connected to the first end of the LED string, and a first capacitor connected between a second end of the first resistor and ground, and the second smoothing circuit may include a second resistor having a first end connected to the second end of the LED string, and a second capacitor connected between a second end of the second resistor and ground.

The LED short detection circuit may further include a buffer configured to have an input terminal connected to the second end of the second resistor, and an output terminal outputting the second smoothing voltage to the amplifier.

The short-circuit signal may indicate a short circuit in response to the detection voltage being lower than the reference voltage.

The short-circuit determination circuit may include a comparator that receives each of the detection voltage and the reference voltage and outputs the short-circuit signal.

An LED system may include an LED driving circuit configured to supply the first LED driving voltage and the second LED driving voltage, and the LED short detection circuit described herein may be configured to receive the first LED driving voltage and the second LED driving voltage.

In another general aspect, light-emitting diode (LED) includes an LED string configured to include a plurality of LEDs, an LED driving circuit configured to supply a first LED driving voltage to a first end of the LED string and a second LED driving voltage to a second end of the LED string, and an LED short detection circuit configured to receive the first LED driving voltage and the second LED driving voltage and generate a short-circuit signal indicating whether a short-circuit has occurred in the LED string, and the LED short detection circuit may include a first smoothing circuit configured to perform smoothing on the first LED driving voltage to output a first smoothing voltage, a second smoothing circuit configured to perform smoothing on the second LED driving voltage to output a second smoothing voltage, an amplifier configured to amplify a difference between the first smoothing voltage and the second smoothing voltage to output a detection voltage, and a short-circuit determination circuit configured to compare the detected voltage with a predetermined reference voltage to output a short-circuit signal.

The LED short detection circuit may further include a buffer configured to receive the second smoothing voltage and output the second smoothing voltage to the amplifier.

The first smoothing circuit may be an RC smoothing circuit configured to generate the first smoothing voltage corresponding to an average value of the first LED driving voltage, and the second smoothing circuit may be an RC smoothing circuit configured to generate the second smoothing voltage corresponding to an average value of the second LED driving voltage.

The short-circuit signal may indicate a short circuit in response to the detection voltage being lower than the reference voltage.

The short-circuit determination circuit may include a comparator that receives each of the detection voltage and the reference voltage and outputs the short-circuit signal.

Other features and aspects will be apparent from the following detailed description, the drawings, and the claims.

BRIEF DESCRIPTION OF DRAWINGS

FIG. 1 illustrates an LED system according to an embodiment.

FIG. 2 illustrates a graph exemplifying LED driving voltages $V_{LED+}$ and $V_{LED-}$, an LED driving current $I_{LED}$, and on/off states of an LED string 300.

FIG. 3 illustrates a block diagram showing a simple internal configuration of an LED short detection circuit.

FIG. 4 illustrates a circuit diagram showing a detailed internal configuration of an LED short detection circuit.

FIG. 5 illustrates a conceptual graph representing LED driving voltages $V_{LED+}$ and $V_{LED-}$ and smoothing voltages $V_{SM+}$ and $V_{SM-}$.

Throughout the drawings and the detailed description, unless otherwise described, the same reference numerals refer to the same elements. The drawings may not be to scale, and the relative size, proportions, and depiction of elements in the drawings may be exaggerated for clarity, illustration, and convenience.

DETAILED DESCRIPTION

Hereinafter, while examples of the present disclosure will be described in detail with reference to the accompanying drawings, it is noted that examples are not limited to the same.

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of this disclosure.

Throughout the specification, when an element, such as a layer, region, or substrate is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween.

As used herein, the term "and/or" includes any one and any combination of any two or more of the associated listed items; likewise, "at least one of" includes any one and any combination of any two or more of the associated listed items.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Spatially relative terms, such as "above," "upper," "below," "lower," and the like, may be used herein for ease of description to describe one element's relationship to another element as shown in the figures. Such spatially relative terms are intended to encompass different orientations of the device in use or operation in addition to the orientation depicted in the figures. For example, if the device in the figures is turned over, an element described as being "above," or "upper" relative to another element would then be "below," or "lower" relative to the other element. Thus, the term "above" encompasses both the above and below orientations depending on the spatial orientation of the device. The device may also be oriented in other ways (rotated 90 degrees or at other orientations), and the spatially relative terms used herein are to be interpreted accordingly.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Due to manufacturing techniques and/or tolerances, variations of the shapes shown in the drawings may occur. Thus, the examples described herein are not limited to the specific shapes shown in the drawings, but include changes in shape that occur during manufacturing.

Herein, it is noted that use of the term "may" with respect to an example, for example, as to what an example may include or implement, means that at least one example exists in which such a feature is included or implemented while all examples are not limited thereto.

The features of the examples described herein may be combined in various ways as will be apparent after an understanding of this disclosure. Further, although the examples described herein have a variety of configurations, other configurations are possible as will be apparent after an understanding of this disclosure.

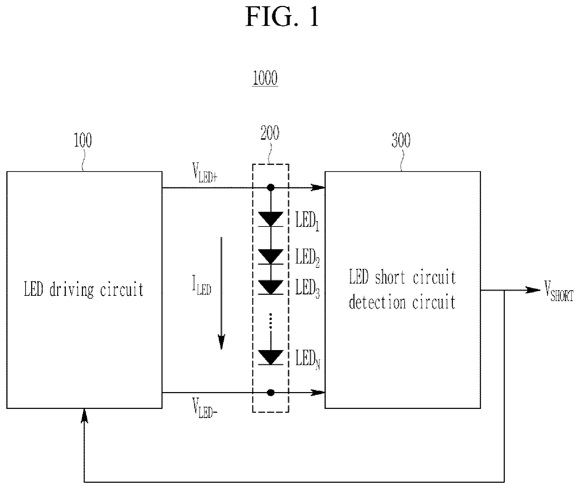

FIG. 1 illustrates an LED system 1000 according to an embodiment.

As shown in FIG. 1, the LED system 1000 may include an LED driving circuit 100, an LED string 200, and an LED circuit detection circuit 300. The LED system 1000 of FIG. 1 may be mounted on a vehicle-mounted camera to emit infrared rays.

The LED driving circuit 100 may generate LED driving voltages $V_{LED+}$ and $V_{LED-}$, which may then be applied to the LED string 200. The LED driving voltage may include a first LED driving voltage $V_{LED+}$ and a second LED driving voltage $V_{LED-}$. The first LED driving voltage $V_{LED+}$ may be applied to a first end of the LED string 200, while the second LED driving voltage $V_{LED-}$ may be applied to a second end of the LED string 200.

The LED driving circuit 100 may include a DC (direct current)-DC (direct current) converter (not shown), and the DC-DC converter may be configured to generate and output the LED voltages $V_{LED+}$ and $V_{LED-}$. As an example, the DC-DC converter may be a boost converter or a buck converter. As an example, the first LED driving voltage $V_{LED+}$ may be a positive (+) voltage, and the second LED driving voltage ($V_{LED-}$) may be a ground voltage. As another example, the first LED driving voltage $V_{LED+}$ and the second LED driving voltage $V_{LED-}$ may both be positive (+) voltages. A method by which the LED driving circuit 100 generates the LED driving voltage is known to those of ordinary skill in the art of the present embodiment, so a detailed description thereof will be omitted.

The LED string 200 may include multiple LEDs $LED_1$ to $LED_N$. Herein, N may be a natural number that is greater than or equal to 2. The LEDs $LED_1$ to $LED_N$ may be connected in series with each other. An anode of the first LED $LED_1$ may be connected to a terminal where the first LED driving voltage $V_{LED+}$ is output, and a cathode of the last LED $LED_N$ may be connected to a terminal where the second LED driving voltage $V_{LED-}$ is output. That is, the first LED $LED_1$ may be a first end of the LED string 200, and the last LED $LED_N$ may be a second end of the LED string 200.

A difference between the first LED driving voltage $V_{LED+}$ and the second LED driving voltage $V_{LED-}$ may enable the LEDs $LED_1$ to $LED_N$ to turn on, allowing them to emit light. Herein, the LED driving circuit 100 may not only apply the LED driving voltages $V_{LED+}$ and $V_{LED-}$ to the LED string 200 may but also control a flow of the LED driving current $I_{LED}$ through the LED string 200. As an example, the LED driving current $I_{LED}$ may be a pulse width modulation (PWM) signal.

The LED short detection circuit 300 may receive the two LED driving voltages $V_{LED+}$ and $V_{LED-}$ applied to the LED string 200 as inputs. The LED short detection circuit 300 may generate a short-circuit signal $V_{SHORT}$ using values corresponding to the two LED driving voltages $V_{LED+}$ and $V_{LED-}$. The short-circuit signal $V_{SHORT}$ generated by the LED short detection circuit 300 may be fed back to the LED driving circuit 100. The short-circuit signal $V_{SHORT}$ may indicate whether at least one LED in the LED string 200 is short-circuited. As an example, if at least one LED in the LED string 200 is short-circuited, the short-circuit signal $V_{SHORT}$ may be at a high level. If no short-circuit occurs in the LED string 200, the short-circuit signal $V_{SHORT}$ may be at a low level.

When the LEDs $LED_1$ to $LED_N$ included in the LED string 200 are turned on, a voltage across the LED string 200, $V_{LED+}$ to $V_{LED-}$, may be expressed by following Equation 1.

## Equation 1:

$$V_{LED+} - V_{LED-} = N * V_F$$

In Equation 1, it is assumed that each of the multiple LEDs $LED_1$ to $LED_N$ has the same turn-on voltage VF.

If no short-circuit occurs in the LED string 200, the voltage across the LED string 200 may correspond to the aforementioned Equation 1.

If a short circuit occurs in one of the multiple LEDs $LED_1$ to $LED_N$, the voltage across the LED string 200 may become (N-1)*VF. Then, if short circuits occur in two of the multiple LEDs $LED_1$ to $LED_N$, the voltage across the LED string 200 may become (N-2)*VF. In this way, when a short circuit occurs in the LED string 200, the voltage across the LED string 200 may decrease (drop), and the LED short detection circuit 300 may detect the short circuit using this principle.

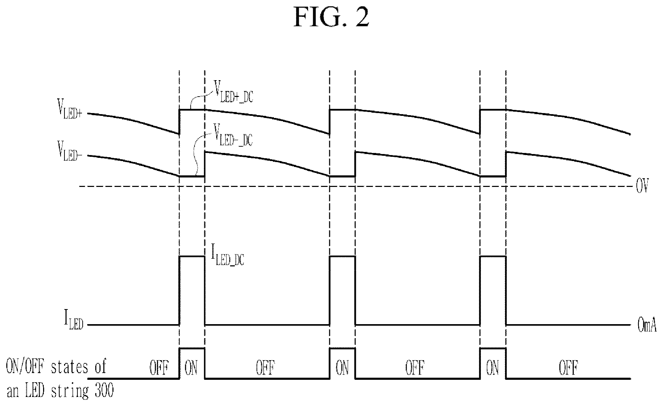

FIG. 2 illustrates a graph exemplifying LED driving voltages $V_{LED+}$ and $V_{LED-}$, an LED driving current $I_{LED}$, and on/off states of an LED string 300. FIG. 2 assumes a case where the LED string 200 is driven in a dimming mode.

As shown in FIG. 2, the LED driving current $I_{LED}$ may be a PWM signal. When the LED driving current $I_{LED}$ is $I_{LED\_DC}$, the LED string 200 may turn on. Then, when the LED driving current $I_{LED}$ is 0mA, the LED string 200 may turn off.

To turn on the LED string 200, the first LED driving voltage $V_{LED+}$ may become a voltage $V_{LED+\_DC}$, and the second LED driving voltage $V_{LED-}$ may become a voltage $V_{LED-\_DC}$. The LED string 200 may be turned on by a difference between the first LED driving voltage $V_{LED+}$ and the second LED driving voltage $V_{LED-}$, specifically $V_{LED+\_DC} - V_{LED-\_DC}$.

Referring to FIG. 2, when the LED string 200 is turned off, the first LED driving voltage $V_{LED+}$ may gradually decrease from the voltage $V_{LED+\_DC}$. A capacitor may be used in the LED driving circuit 100 to output the first LED driving voltage $V_{LED+}$, and due to this capacitor, the first LED driving voltage $V_{LED+}$ may gradually decrease from the voltage $V_{LED+\_DC}$. Meanwhile, when the LED string 200 is turned off, the second LED driving voltage $V_{LED-}$ may float and follow the first LED driving voltage $V_{LED+}$. That is, when the LED string 200 is turned off, the second LED driving voltage $V_{LED-}$ may slightly increase from the voltage $V_{LED-\_DC}$ before gradually decreasing.

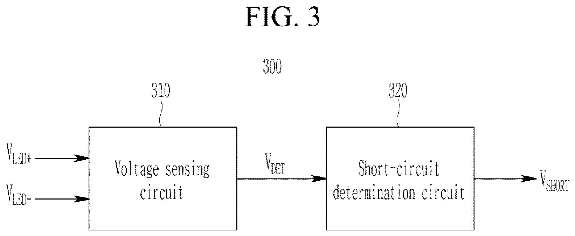

FIG. 3 illustrates a block diagram showing a simple internal configuration of an LED short detection circuit 300.

As shown in FIG. 3, the LED short detection circuit 300 may include a voltage sensing circuit 310 and a short-circuit determination circuit 320.

The voltage sensing circuit 310 may receive the first LED driving voltage $V_{LED+}$ and the second LED driving voltage $V_{LED-}$ as inputs. The voltage sensing circuit 310 may amplify a difference between values corresponding to the two input LED driving voltages $V_{LED+}$ and $V_{LED-}$, and may output the amplified signal as a detection voltage $V_{DET}$.

The short-circuit determination circuit 320 may receive the detection voltage $V_{DET}$ from the voltage sensing circuit (310), compare the detection voltage $V_{DET}$ with a predetermined reference voltage to generate the short-circuit signal $V_{SHORT}$. As an example, if the detection voltage $V_{DET}$ is lower than the reference voltage, the short-circuit signal $V_{SHORT}$ may become high level. Then, if the detection voltage $V_{DET}$ is higher than the reference voltage, the short-circuit signal $V_{SHORT}$ may become low level.

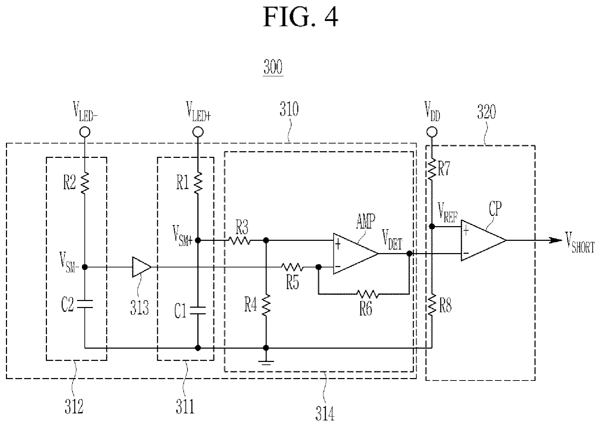

FIG. 4 illustrates a circuit diagram showing a detailed internal configuration of the LED short detection circuit 300.

As shown in FIG. 4, the voltage sensing circuit 310 may include a first smoothing circuit 311, a second smoothing circuit 312, a buffer 313, and a differential amplifier 314.

The first smoothing circuit 311 may include a resistor R1 and a capacitor C1. A first end of the resistor R1 may be applied with the first LED driving voltage $V_{LED+}$. That is, the first end of the resistor R1 may be connected to a first end of the LED string 200, and it may receive the first LED driving voltage $V_{LED+}$. The capacitor C1 may be connected between a second end of the resistor R1 and ground. The first smoothing circuit 311 has an RC smoothing circuit structure, and a first smoothing voltage $V_{SM+}$ may be generated across the capacitor C1.

The second smoothing circuit 312 may include a resistor R2 and a capacitor C2. A first end of the resistor R2 may be applied with the second LED driving voltage $V_{LED-}$. That is, the first end of the resistor R2 may be connected to a second end of the LED string 200, and it may receive the second LED driving voltage $V_{LED-}$. The capacitor C2 may be connected between a second end of the resistor R2 and ground. The second smoothing circuit 312 has an RC smoothing circuit structure, and a second smoothing voltage $V_{SM-}$ may be generated across the capacitor C2.

The buffer 313 may receive the second smoothing voltage $V_{SM-}$ from the second smoothing circuit 312 and output the second smoothing voltage $V_{SM-}$ to the differential amplifier 314. Herein, an input terminal of the buffer 313 may be connected to the second end of the resistor R2, and an output terminal of the buffer 313 may be connected to a resistor R5 of the differential amplifier 314.

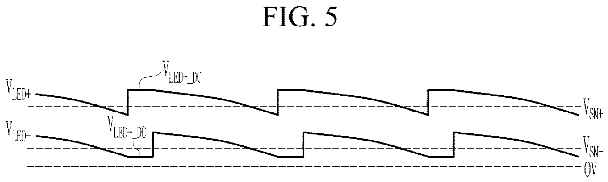

FIG. 5 illustrates a conceptual graph representing LED driving voltages $V_{LED+}$ and $V_{LED-}$ and smoothing voltages $V_{SM+}$ and $V_{SM-}$.

As described in FIG. 2, when the LED driving current $I_{LED}$ is a PWM signal, the LED driving voltages $V_{LED+}$ and $V_{LED-}$ may have fluctuating voltage values. That is, referring to FIG. 2 and FIG. 5, the first LED driving voltage $V_{LED+}$ may have a variable voltage value, and the second LED driving voltage $V_{LED-}$ may also have a variable voltage value.

The first smoothing circuit 311 may perform smoothing on the first LED driving voltage $V_{LED+}$, which has a fluctuating voltage value, to generate the first smoothing voltage $V_{SM+}$. That is, through the first smoothing circuit 311, an AC component in the first LED driving voltage $V_{LED+}$ may be removed, and the first smoothing voltage $V_{SM+}$ may be a DC voltage, as shown in FIG. 5. Herein, a value of the first smoothing voltage $V_{SM+}$ may correspond to an average value of the first LED driving voltage $V_{LED+}$.

The second smoothing circuit 312 may perform smoothing on the second LED driving voltage $V_{LED-}$ which has a fluctuating voltage value, to generate the second smoothing voltage $V_{SM-}$. That is, through the second smoothing circuit 312, an AC component in the second LED driving voltage $V_{LED-}$ may be removed, and the second smoothing voltage $V_{SM-}$ may be a DC voltage, as shown in FIG. 5. Herein, a value of the second smoothing voltage $V_{SM-}$ may correspond to an average value of the second LED driving voltage $V_{LED-}$.

The differential amplifier 314 may receive the first smoothing voltage $V_{SM+}$ from the first smoothing circuit 311 and the second smoothing voltage $V_{SM-}$ from the second smoothing circuit 312. The differential amplifier 314 may amplify a difference between the first smoothing voltage $V_{SM+}$ and the second smoothing voltage $V_{SM-}$, which are received, to output the detection voltage $V_{DET}$. Herein, the second smoothing voltage $V_{SM-}$ may pass through the buffer 313 to be supplied to the differential amplifier (314). In the absence of the buffer 313, the second smoothing voltage $V_{SM-}$ may be coupled with an output terminal of the differential amplifier 314, potentially being affected. The buffer 313 may prevent such an effect, and the second smoothing voltage $V_{SM-}$ may pass through the buffer 313 to be supplied unchanged to the differential amplifier 314.

The differential amplifier 314 may include an amplifier AMP, a resistor R3, a resistor R4, a resistor R5, and a resistor R6.

The amplifier AMP may be an operational amplifier, and may have a non-inverting terminal (+), an inverting terminal (-), and an output terminal. The resistor R3 may be connected between a second terminal of the resistor R1 and the non-inverting terminal (+) of the amplifier AMP. The resistor R4 may be connected between the non-inverting terminal (+) of the amplifier AMP and ground. The resistor R5 may be connected between the output terminal of the buffer 313 and the inverting terminal (-) of the amplifier AMP. Then, the resistor R6 may be connected between the inverting terminal (-) and the output terminal of the amplifier AMP. A voltage at the output terminal of the amplifier AMP may serve as the detection voltage $V_{DET}$.

In the differential amplifier 314, a relationship among the first smoothing voltage $V_{SM+}$, the second smoothing voltage $V_{SM-}$, and the detection voltage $V_{DET}$ may be as shown in Equation 2 below.

Equation 2:

$$V_{DET} = \frac{R6}{R5}\left(V_{SM+} - V_{SM-}\right)$$

In Equation 2, it is assumed that R3 = R5 and R4 = R6.

Referring to Equation 2, the detection voltage $V_{DET}$, which is an output of the differential amplifier 314, may correspond to a product of a difference between the first smoothing voltage $V_{SM+}$ and the second smoothing voltage $V_{SM-}$ and a resistance ratio (R6/R5).

As shown in FIG. 4, the short-circuit determination circuit 320 may include a comparator CP, a resistor R7, and a resistor R8.

The comparator CP may have a non-inverting terminal (+), an inverting terminal (-), and an output terminal. A first end of resistor R7 may be applied with a power supply voltage VDD, and a second end of the resistor R7 may be connected to the non-inverting terminal (+) of the comparator CP. The resistor R8 may be connected between the non-inverting terminal (+) of the comparator CP and ground. The inverting terminal (-) of the comparator CP may receive the output voltage of the differential amplifier 314, that is, the detection voltage $V_{DET}$.

Herein, a reference voltage $V_{REF}$ may be input to the non-inverting terminal (+) of the comparator CP, and the reference voltage $V_{REF}$ may be determined based on voltage-resistance division, as shown in Equation 3 below.

Equation 3:

$$V_{REF} = \frac{R8}{R7+R8}\ V_{DD}$$

The comparator CP may compare the reference voltage $V_{REF}$ with the detection voltage $V_{DET}$ to output the short-circuit signal $V_{SHORT}$. When the detection voltage $V_{DET}$ is lower than the reference voltage $V_{REF}$, the comparator CP outputs the short-circuit signal $V_{SHORT}$ with a high level. Then, when the detection voltage $V_{DET}$ is higher than the reference voltage $V_{REF}$, the comparator CP may output the short-circuit signal $V_{SHORT}$ with a low level. Herein, the reference voltage $V_{REF}$ may be set to correspond to a degree to which a voltage between the two terminals of the LED string 200 drops when a short circuit occurs in the LED string 200.

As described above, if a short circuit occurs in at least one of the multiple LEDs $LED_1$ to $LED_N$ included in the LED string 200, a voltage across opposite ends of the LED string 200 may decrease. That is, the difference value between the first LED driving voltage $V_{LED+}$ and the second LED driving voltage $V_{LED-}$ may decrease, and the difference value between the first smoothing voltage $V_{SM+}$ and the second smoothing voltage $V_{SM-}$ may also decrease. Accordingly, the detection voltage $V_{DET}$, which is the output voltage of the differential amplifier 314, may decrease, and the detection voltage $V_{DET}$ may become lower than the reference voltage VREF. When the detection voltage $V_{DET}$ becomes lower than the reference voltage $V_{REF}$, the comparator CP outputs the short-circuit signal $V_{SHORT}$ with a high level. Herein, the short-circuit signal $V_{SHORT}$ with a high level may indicate that a short circuit has occurred in the LED string 200.

At least one embodiment of the embodiments attempts to provide an LED short detection circuit capable of detecting a short circuit in at least one LED among a plurality of LEDs.

According to at least one embodiment of the embodiments, it may be possible to detect a short circuit occurring in at least one LED included in an LED string.

While specific examples have been shown and described above, it will be apparent after an understanding of this disclosure that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

**Claims**

1.   A light-emitting diode (LED) short detection circuit, comprising:

     a first smoothing circuit configured to receive a first LED driving voltage applied to a first end of an LED string and perform smoothing on the first LED driving voltage;
     a second smoothing circuit configured to receive a second LED driving voltage applied to a second end of the LED string and perform smoothing on the second LED driving voltage;
     an amplifier configured to amplify a difference between a first smoothing voltage output from the first smoothing circuit and a second smoothing voltage output from the second smoothing circuit to output a detection voltage; and
     a short-circuit determination circuit configured to compare the detection voltage with a predetermined reference voltage to output a short-circuit signal indicating whether a short-circuit has occurred.

2.   The LED short detection circuit of claim 1, further comprising
     a buffer configured to receive the second smoothing voltage and output the second smoothing voltage to the amplifier.

3.   The LED short detection circuit of claim 1, wherein

the first smoothing circuit comprises a first resistor having a first end connected to the first end of the LED string, and a first capacitor connected between a second end of the first resistor and ground, and
the second smoothing circuit comprises a second resistor having a first end connected to the second end of the LED string, and a second capacitor connected between a second end of the second resistor and ground.

4.   The LED short detection circuit of claim 3, further comprising
     a buffer configured to have an input terminal connected to the second end of the second resistor, and an output terminal outputting the second smoothing voltage to the amplifier.

5.   The LED short detection circuit of claim 1, wherein the short-circuit signal indicates a short circuit in response to the detection voltage being lower than the reference voltage.

6.   The LED short detection circuit of claim 5, wherein the short-circuit determination circuit comprises a comparator that receives each of the detection voltage and the reference voltage and outputs the short-circuit signal.

7.   An LED system comprising:

     an LED driving circuit configured to supply the first LED driving voltage and the second LED driving voltage; and
     the LED short detection circuit of claim 1 configured to receive the first LED driving voltage and the second LED driving voltage.

8.   A light-emitting diode (LED) system comprising:

     an LED string configured to comprise a plurality of LEDs;
     an LED driving circuit configured to supply a first LED driving voltage to a first end of the LED string and a second LED driving voltage to a second end of the LED string; and
     an LED short detection circuit configured to receive the first LED driving voltage and the second LED driving voltage, and generate a short-circuit signal indicating whether a short-circuit has occurred in the LED string,
     wherein the LED short detection circuit comprises:

         a first smoothing circuit configured to perform smoothing on the first LED driving voltage to output a first smoothing voltage;
         a second smoothing circuit configured to perform smoothing on the second LED driving voltage to output a second smoothing voltage;

an amplifier configured to amplify a difference between the first smoothing voltage and the second smoothing voltage to output a detection voltage; and

a short-circuit determination circuit configured to compare the detection voltage with a predetermined reference voltage to output a short-circuit signal.

9.  The LED system of claim 8, wherein

the LED short detection circuit further comprises a buffer configured to receive the second smoothing voltage and output the second smoothing voltage to the amplifier.

10.  The LED system of claim 8, wherein

the first smoothing circuit is an RC smoothing circuit configured to generate the first smoothing voltage corresponding to an average value of the first LED driving voltage, and

the second smoothing circuit is an RC smoothing circuit configured to generate the second smoothing voltage corresponding to an average value of the second LED driving voltage.

11.  The LED system of claim 8, wherein the short-circuit signal indicates a short circuit in response to the detection voltage being lower than the reference voltage.

12.  The LED system of claim 11, wherein the short-circuit determination circuit comprises a comparator that receives each of the detection voltage and the reference voltage, and outputs the short-circuit signal.

EP 4 739 002 A1

FIG. 1

1000

100

200

300

V_LED+

LED driving circuit

I_LED

LED₁

LED₂

LED₃

LED_N

V_LED-

LED short circuit detection circuit

V_SHORT

9

# FIG. 2

# FIG. 3

300

310

320

$V_{LED+}$ ——→ | Voltage sensing circuit | $V_{DET}$ ——→ | Short-circuit determination circuit | ——→ $V_{SHORT}$

$V_{LED-}$ ——→

FIG. 4

FIG. 5

## EUROPEAN SEARCH REPORT

Application Number

EP 25 20 3982

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2012/181931 A1 (KATSURA KOJI [JP]) 19 July 2012 (2012-07-19) * paragraph [0001] - paragraph [0146]; figures 1-24 * | 1-12 | INV.<br>H05B45/54<br>G01R31/52 |
| Y | US 2015/301128 A1 (KOVATCHEV EMIL [AT] ET AL) 22 October 2015 (2015-10-22) * paragraph [0001] - paragraph [0050]; figures 1-5 * | 1-12 | |
| A | US 2006/170287 A1 (ITO MASAYASU [JP] ET AL) 3 August 2006 (2006-08-03) * paragraph [0001] - paragraph [0084]; figures 1-5 * | 1-12 | |

TECHNICAL FIELDS
SEARCHED      (IPC)

H05B

The present search report has been drawn up for all claims

| Place of search | Date of completion of the search | Examiner |
|---|---|---|
| Munich | 6 February 2026 | Beaugrand, Francois |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 3982

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2026

| Patent document cited in search report | Publication date | Patent family member(s) | | Publication date |
|---|---|---|---|---|
| US 2012181931 A1 | 19-07-2012 | JP | 5901966 B2 | 13-04-2016 |
| | | JP | 2012160436 A | 23-08-2012 |
| | | US | 2012181931 A1 | 19-07-2012 |
| US 2015301128 A1 | 22-10-2015 | CN | 104704916 A | 10-06-2015 |
| | | DE | 102012218772 B3 | 30-10-2014 |
| | | US | 2015301128 A1 | 22-10-2015 |
| | | WO | 2014060288 A1 | 24-04-2014 |
| US 2006170287 A1 | 03-08-2006 | JP | 2006210219 A | 10-08-2006 |
| | | US | 2006170287 A1 | 03-08-2006 |

EPO FORM P0459

For more details about this annex : see Official Journal of the European Patent Office, No. 12/82